# EUROPÄISCHE PATENTSCHRIFT

(11) **EP 0 404 891 B1**
(45) Veröffentlichungstag und Bekanntmachung des Hinweises auf die Patenterteilung: **01.06.1994**
(21) Anmeldenummer: 89913059.5
(22) Anmeldetag: 24.10.1989
(51) Int. Cl.: H05K 3/40

(54) **VERFAHREN ZUR HERSTELLUNG ELEKTRISCH LEITFÄHIGER STRUKTUREN**
PROCESS FOR THE MANUFACTURE OF ELECTRICALLY CONDUCTIVE STRUCTURES
PROCEDE POUR LA MANUFACTURE DE STRUCTURES ELECTRO-CONDUCTRICES

(30) Priorität: 27.10.1988 DE 3836605; 26.09.1989 DE 3932017
(43) Veröffentlichungstag der Anmeldung: 02.01.1991
(73) Patentinhaber: BAYER AG, 51368 Leverkusen (DE)
(72) Erfinder: GIESECKE, Henning, D-5000 Köln 80 (DE); WILDE, Horst-Dieter, D-5828 Ennepetal (DE); BONACK, Armin, D-5650 Solingen (DE)
(86) Internationale Anmeldenummer: EP8901268
(87) Internationale Veröffentlichungsnummer: WO9004913

(56) Entgegenhaltungen:
- EP-A- 0 044 247
- EP-A- 0 075 890
- WO-A-88/02592
- US-A- 4 728 751
- HANDBOOK OF PRINTED CIRCUIT DESGIN, MANUFACTURE,COMPONENTS & ASSEMBLY, G.Leonida, Electrochemical Publications Limited, Ayr,Scotland, 1981, Seiten 321-330

## Beschreibung

Die vorliegende Erfindung betrifft die Herstellung elektrisch leitender Strukturen, z.B. gedruckter elektrischer Schaltungen. Es ist bereits bekannt, daß elektrisch leitfähige Strukturen aus einer auf einem Träger aufgebrachten Metallfolie durch Wegätzen von Teilen der Metallfolie gebildet werden. Eine derart hergestellte Leiterplatte hat wegen der aus reinem Metall bestehenden Leiterbahnen den Vorteil eines geringen Leitungswiderstandes. Nachteilig ist der große Herstellungsaufwand,

Mit wesentlich geringerem Herstellungsaufwand und höherer Präzision lassen sich gedruckte elektrische Schaltungen nach einem anderen Verfahren herstellen, das auch für mehrlagige elektrische Schaltungen (Multilayer) geeignet ist. Bei diesem Verfahren werden die elektrisch leitfähigen Strukturen durch Aufdrucken einer leitfähigen Paste, z.B. einer Silberpaste, insbesondere im Siebdruck auf einem isolierenden Träger hergestellt. Der Nachteil bei solchen gedruckten Schaltungen besteht darin, daß wegen des in der Paste enthaltenen Bindemittels und der Größe der Silberpartikel die Leitfähigkeit der Paste nicht besonders gut ist. Deshalb ist es üblich, verhältnismäßig dicke Leiterbahnen (8 bis 12 µm) aufzudrucken. Hinzu kommt, daß bei Verwendung einer Silberpaste das Silber zwischen benachbarten Leiterbahnen unterschiedlichen Potentials bei Einwirkung von Feuchtigkeit migriert und zu Kriechströmen und sogar Kurzschlüssen führt. Deshalb ist es erforderlich, die Leiterbahnen durch besondere Schutzfilme zu schützen. Ein weiterer Nachteil besteht darin, daß sich auf die Leiterbahnen keine Bauteile auflöten lassen (DE 34 13 408).

Weiterhin ist ein Verfahren zur Herstellung von gedruckten elektrischen Schaltungen bekannt, bei dem auf einem isolierenden Träger eine einen Aktivator enthaltende Formulierung (pastöse Substanz) entsprechend der gewünschten Struktur aufgedruckt wird und anschließend auf dem mit dieser Formulierung bedruckten Teil der Oberfläche des isolierenden Trägers in einem Metallisierungsbad Metall abgeschieden wird. In diesem Fall werden rein metallische Strukturen geringer Dicke erreicht. Trotz dieses Vorteils konnte sich dieses seit mehreren Jahrzehnten bekannte Verfahren in der Praxis gegenüber den beiden anderen Verfahren nicht durchsetzen (DE 11 76 731).

Ein Verfahren zum Herstellen von elektrisch leitenden Strukturen, bei dem eine Substanz, die aus organometallischen Aktivatoren, organischen Lösungsmitteln, Füllstoffen und Bindemitteln besteht, eingesetzt wird, ist aus der DE 32 41 579 bekannt, Ferner sind Verfahren zur Herstellung gedruckter Schaltungen in der DE 26 35 457 und DE 27 37 582 beschrieben, Aus DE 34 13 408, DE 30 06 117, DE 25 58 367 und DE 30 32 931 sind darüber hinaus Verfahren zum Herstellen von mehrlagigen gedruckten Schaltungen bekannt.

Trotz der aufgezeigten Nachteile von im Siebdruck unter Verwendung von einer elektrisch leitenden Metallpaste, insbesondere Silberpaste, gedruckten elektrischen Schaltungen hat dieses Verfahren sich für viele Anwendungen, wo hohe Anforderungen an die Genauigkeit des Leiterbildes gestellt sind, bewährt, Im Zuge der technischen Entwicklung steigen jedoch die Anforderungen an die Genauigkeit. Gefordert werden gedruckte elektrisch leitende Strukturen höchster Präzision bei möglichst geringer Dicke der Metallschicht. Eine Schwierigkeit, diese Anforderungen zu erfüllen, besteht vor allem darin, schmale Strukturen ausreichend dauerhaft und fest mit dem Träger zu verbinden.

Diese Forderung konnte gemäß DE 37 33 002 durch eine elektrisch leitende Struktur erfüllt werden, die aus einem Träger mit insbesondere isolierender Oberfläche und einer auf der Oberfläche mit einer einen Aktivator enthaltenden, aufgedruckten Substanz stromlos aus einem Metallisierungsbad abgeschiedenen Metallschicht besteht, wobei die Substanz organometallische Aktivatoren, Füllstoffe, organische Lösungsmittel und Bindemittel enthält. Solche Strukturen haften fest auf der Oberfläche des Substrats, so daß es nicht zu einem unbeabsichtigten Ablösen der Leiterbahn kommen kann.

Nachteilig bei diesen elektrisch leitenden Strukturen ist, daß sich die Leiterenden nicht zwecks Herstellung von freistehenden metallischen Anschlußbereichen ablösen lassen. Bisher war man daher darauf angewiesen, den Anschluß- und Steckerbereich nach einem komplizierten Verfahren auszubilden, nachdem entweder die Anschlüsse (Pins) mechanisch befestigt werden (Schneid-Klemm-Technik) oder gestanzt werden.

In dem Lehrbuch Handbook of Printed Circuit Design, Manufacture, Components & Assembly, G. Lenonida, Electrochemical Publications Ltd., Agr, Scotland, 1981, sind auf den Seiten 321 bis 330 elektrisch leitende Strukturen mit in der Ebene des Trägers über diesen hinausgehenden Anschlüssen beschrieben.

Aus US 4.728.751 sind elektrisch leitende Strukturen auf Trägern bekannt, auf die elektronische Bauteile aufgesteckt werden können. Hierzu besitzen diese Strukturen freistehende metallische Teile, die senkrecht aus der Ebene des Trägers herausstehen. Zwischen den elektrischen Leiterbahnen und dem Träger ist in den Bereichen, wo die elektronischen Bausteine aufgesteckt werden, eine verminderte Haftfestigkeit vorgesehen. Allerdings wird das Kupfer für die Leiterbahnen nicht in einem naßchemischen Prozeß aufgebracht, sondern mit Hilfe fertig vorbereiteter Kupferfolie, die mit einer Schicht vorbereitet ist, die späteres Ablösen ermöglicht.

Gegenstand der vorliegenden Erfindung ist ein Verfahren zur Herstellung von ein- oder mehrlagigen elektrisch leitenden Strukturen mit Anschluß- und Steckerbereichen, die in der Ebene des Trägers über diesen hinausgehen, nachdem der ursprünglich auch unter diesen Anschlüssen und Steckern vorhandene Träger ohne deren Beschädigung abgelöst worden ist, durch Aufbringen einer organometallische Aktivatoren enthaltenden Formulierung auf die Trägeroberfläche und anschließende naßchemisch-stromlose Metallisierung, wobei sowohl die Leiterbahnen als auch die Anschluß- und Steckerbereiche in einem Arbeitsgang metallisiert werden und dabei die Metallschicht in den Anschluß- und Steckerbereichen mit einer so geringen Haftfestigkeit abgeschieden wird, daß sie leicht von der Substratoberfläche ohne deren Beschädigung abgelöst werden kann.

Für die stromlose Metallisierung geeignete katalytisch wirksame Formulierungen werden z.B. in den DE 37 43 780, DE 36 27 256 und DE 36 25 587 erwähnt Als Bindemittel und Lösemittel kommen insbesondere diejenigen gemäß DE 37 33 002 in Betracht. Bevorzugt sind Polyurethanelastomere in Kombination mit halogenfreien Lösungsmitteln.

Die Herstellung der Substanzen geschieht im allgemeinen durch Vermischen der Bestandteile. Dazu sind neben dem einfachen Rühren besonders die in der Lack- und Drucktechnik üblichen Naßverkleinerungsaggregate wie Kneter, Attritore, Walzenstühle, Dissolver, Rotor-Stator-Mühlen; Kugelmühlen sowie Rührwerkmühlen besonders geeignet. Selbstverständlich kann das Einarbeiten der Formulierungsbestandteile auch in getrennten Schritten durchgeführt werden. Beispielsweise kann man den Aktivator zuerst in den Bindern und Lösungsmitteln lösen bzw. dispergieren und dann erst die Füllstoffe einarbeiten. Auch ein vorheriges Einbringen der Füllstoffe in die Lösungsmittel unter hohen Scherkräften ist eine mögliche Verfahrensvariante.

Das Aufbringen der Formulierungen erfolgt im allgemeinen durch aus der Lack- bzw. Drucktechnik bekannte Verfahren, z.B. durch Aufsprühen, Aufstreichen, Aufrollen, Tauchen, Beschichten, Drucken (z.B. auf Offfset-Druck, Siebdruck, Tampon-Druck) oder nach dem Ink-Jet-Verfahren.

Als Substrate für das erfindungsgemäße Verfahren eignen sich Glas, Quarz, Keramik, Emaille, Papier, Polyethylen, Polypropylen, Epoxidharze, Polyester, Polycarbonate, Polyamide, Polyimide, Polyhydantoine, ABS-Kunststoffe, Silikone, Polyvinylhalogenide, Polyvinylidenfluorid in Form von Platten, Folien, Papieren und Vliesen. Besonders bevorzugt sind Substrate, wie sie in der Leiterplattenfertigung eingesetzt werden, z.B. Phenolharzpapiere, glasfaserverstärkte Epoxidplatten, Polyester-, Polyimidfolien und Keramik.

Geeignete Füllstoffe sind insbesondere disperse Kieselsäuren und Titandioxid.

Geeignete Aktivatoren sind insbesondere solche, die in den EP 34 485, EP 81 438 oder EP 131 195 aufgeführt sind.

Nach dem Aufbringen der Formulierungen auf die Trägeroberfläche werden die Lösungsmittel entfernt. Im allgemeinen geschieht dies durch Trocknen.

Die mit den Formulierungen aktivierten Oberflächen werden in einem weiteren Verfahrensschritt stromlos metallisiert. Dafür kommen besonders Bäder mit Nickel-, Kobalt-, Eisen-, Kupfer-, Silber-, Gold- und Palladiumsalzen oder deren Gemische in Betrachte Derartige Metallisierungsbäder sind in der Technik der stromlosen Metallisierung bekannt.

Ein weiterer Gegenstand der Erfindung ist ein Verfahren zur Herstellung von ein- oder mehrlagigen elektrisch leitenden Strukturen mit Anschluß- und Steckerbereichen, die in der Ebene des Trägers über diesen hinausgehen, nachdem der ursprünglich auch unter diesen Anschlüssen und Steckern vorhandene Träger ohne deren Beschädigung abgelöst worden ist, durch Aufbringen einer organometallische Aktivatoren enthaltenden Formulierung auf die Trägeroberfläche und anschließende naßchemisch-stromlose Metallisierung, wobei für die Anschluß- und Steckerbereiche eine thermoplastische Bindemittel enthaltende Aktivatorformulierung verwendet wird, die eine Ablösung der Metallschicht durch Erwärmen auf 60 - 300°C, vorzugsweise 100 - 250°C ermöglicht, während das Leiterbild unter diesen Bedingungen festhaftend bleibt.

Hierbei werden sowohl die Leiterbahnen als auch die Anschluß- und Steckerbereiche in einem Arbeitsgang metallisiert und dabei die Metallschicht in diesen Bereichen mit einer so geringen Haftfestigkeit abgeschieden, daß sie leicht von der Substratoberfläche ohne deren Beschädigung abgelöst werden kann.

Die Ablösung der Metallschicht erfolgt besonders bevorzugt bei 100 - 200°C.

Dabei ist es zweckmäßig, die Erweichungstemperatur der verwendeten thermoplastischen Bindemittel durch geeignete Maßnahmen zu senken. Bei Polyurethanelastomeren erreicht man dies beispielsweise durch höhere Anteile an aliphatischen Komponenten oder niedrige (Isocyanat)-Kennzahlen.

Die Haftfestigkeit kann beispielsweise durch Messverfahren nach DIN 40633, 53151 und 53494 (VIC) bestimmt werden. Die nach diesem Verfahren abgeschiedenen Metallschichten weisen im Anschlußbereich Haftfestigkeiten von weniger als 15 N / 25 mm (N/inch), bevorzugt 1 - 10 N / 25 mm (N/inch), auf.

Die Haftfestigkeit der Metallschichten im Bereich des Leiterbildes sollte demgegenüber mindestens 20 N / 25 mm (N/inch), vorzugsweise mindestens 25 N / 25 mm (N/inch), betragen.

Zur Erzeugung der Metallschichten mit verminderter Haftfestigkeit bieten sich mehrere Verfahrensvarianten an.

Eine Variante besteht darin, daß man eine Änderung von Art und Gehalt der Bindemittel und Füllstoffe in den üblichen Druckpasten vornimmt. Solche Maßnahmen sind aus der Drucktechnik allgemein bekannt.

Beispielsweise bewirkt eine Senkung des Anteils des häufig verwendeten Aerosils, bezogen auf das Bindemittel in Polyurethanelastomeren enthaltenden Formulierungen, von 40 Gew.-% auf 25 Gew.-% eine Verringerung der Haftfestigkeiten der darauf abgeschiedenen Metallschichten von mehr als 20 N/25 mm auf ca. 5 N/mm. Eine haftvermindernde Variation der Füllstoffe kann beispielsweise auch in Zusätzen von Graphit- oder Talkumanteilen bestehen.

Bei Verwendung von Acrylabbindern erreicht man eine Verminderung der Haftfestigkeit beispielsweise durch Herabsetzung des Acrylnitrilanteils oder durch Einführung längerer aliphatischer Seitenketten in die Acrylesterkomponente.

Aber auch der Zusatz von haftvermindernden Zusätzen, wie z.B. nichtionischen Tensiden, Alkylsulfonaten, Seifen, Paraffinen, Siliconen ist oftmals vorteilhaft.

Eine zweite Möglichkeit besteht darin, daß nur gut haftende Formulierungen zu verwenden und diese durch chemische oder physikalische Vorbehandlung des Substrates in den Anschlußbereichen in ihrer Haftfestigkeit herabzusetzen sind. Als Beispiele für chemische Vorbehandlungen seien Beschichtungen mit Trennmitteln, Lacken, Ätzen und Bedampfen genannt. Als physikalisches Vorbehandlungsverfahren haben sich Sand-Strahl-Verfahren und Coronar-Entladungen bewährt.

Als Trennmittel kommen insbesondere Silicone in Betracht. Geeignetes Ätzmittel ist z.B. Chromschwefelsäure. Das Bedampfen kann beispielsweise mit Siloxanen erfolgen.

Schließlich ist es möglich, daß man die Stecker- und Anschlußbereiche auf einem anderen Substrat erzeugt, das beispielsweise durch Verschweißen, Verkleben oder mittels Beschichtungen mit dem Trägersubstrat verbunden ist. Das andere Substrat kann dabei so ausgewählt werden, daß die Haftfestigkeit der darauf bei der Metallisierung entstehenden elektrisch leitenden Strukturen herabgesetzt sind. Es ist aber auch möglich, dazu solche Materialien zu verwenden, die anschließend leicht zu entfernen sind, beispielsweise durch Auflösen in Ätz- oder Lösungsmitteln.

Diese Verfahrensvariante hat den Vorteil, daß das Trägersubstrat nach Ablösung der freistehenden Strukturen nicht mehr entfernt werden muß.

Auf den organometallische Aktivatoren enthaltenden Formulierungen können Metallschichten beispielsweise auf folgende Weisen abgeschieden werden.

Die Substanzen werden nur an den Stellen aufgebracht, die später elektrisch leitend sein sollen. Die Zwischenräume bleiben frei. Anschließend werden additiv bevorzugt 0,5 - 5 µm starke Metallschichten abgeschieden, die dann gegebenenfalls galvanisch verstärkt werden können, selbstverständlich nach Anbringung einer geeigneten Kontaktierung.

Danach werden die Metallstrukturen in den Anschlußbereichen wie beschrieben abgelöst und gegebenenfalls das Substrat in dem Stecker- und Anschlußbereich entfernt.

Selbstverständlich kann auch die gesammte Metallschicht rein additiv aufgebaut werden.

Eine zweite Möglichkeit zum Aufbau einer erfindungsgemäßen metallischen Struktur besteht darin, daß die organometallischen Substanzen flächig aufgetragen werden und die Strukturierung semiadditiv durchgeführt wird, Diese Variante führt erfahrungsgemäß zu Strukturen mit einer hohen Maßgenauigkeit und ist daher insbesondere zur Herstellung von Feinstleiterstrukturen geeignet. Die Ablösung der freistehenden Strukturteile erfolgt anschließend wie vorab beschrieben.

Selbstverständlich können die metallischen Strukturen auch gegen Korrosion geschützt werden. Derartige Verfahren sind in der Galvanik- und Leiterplattenindustrie hinlänglich bekannt. Als Beispiele seien das Aufbringen von Schutzlacken, Nickel, Gold, Palladiumlegierungen und Zinn genannt. Natürlich ist es auch möglich, nur die freistehenden Anschluß- und Steckerbereiche auf diese Art zu schützen.

Die Anwendungsmöglichkeiten der nach dem erfindungsgemäßen Verfahren hergestellten Schaltungen sind vielfältig, z.B. flexible und starre Schaltungen bzw. Strukturen, Abschirmungen, Tastaturen, Sensoren, Endlosleiter, Folienverbinder. Die erfindungsgemäßen elektrisch leitenden Strukturen können selbstverständlich nach der Herstellung durch Aufbringen verschiedener Substanzen ganz oder partiell geschützt und/oder isoliert werden. Solche Verfahren sind aus der Elektrotechnik allgemein bekannt (z.B. Sprühen, Drucken, Spritzen, Tauchen, Beschichten).

Erfindungsgemäß herstellbar ist weiterhin eine mehrlagige gedruckte elektrische Schaltung mit integrierten freistehenden metallischen Anschlußbereichen, deren elektrisch leitende Strukturen in den einzelnen Lagen durch insbesondere aufgedruckte, isolierende Zwischenlagen elektrisch voneinander getrennt sind. Bei dieser Schaltung ist vorgesehen, daß die Strukturen aus mittels einer einen Aktivator enthaltenden Substanz stromlos auf der isolierenden Oberfläche des Trägers und der jeweiligen isolierenden Zwischenlage abgeschiedenen Metallschicht bestehen. Sofern die Strukturen in den einzelnen Lagen elektrisch miteinander verbunden sein sollen, ist weiter vorgesehen, daß die isolierenden Zwischenlagen Aussparungen für die Durchkontaktierung aufweisen und im Bereich der Aussparungen auf die Struktur der jewelligen unteren Lage die Substanz vollflächig oder partiell aufgedruckt ist. Bei dieser Ausgestaltung wird ein elektrisch leitfähiger Kontakt zwischen der unteren Metallschicht, auf der die Substanz vollflächig oder partiell aufgedruckt ist, und der auf der Substanz stromlos abgeschiedenen Metallschicht überraschenderweise erhalten.

Bei diesen mehrlagigen Schaltungen lassen sich ebenfalls nach den geschilderten Verfahren in den Anschluß- und Steckerbereichen freistehende metallische elektrisch leitende Strukturen herstellen. Hierbei können auch partiell nur bestimmte Schichten freigelegt werden, während andere Schichten ohne freistehende metallische Anschlußbereiche hergestellt werden.

Die erfindungsgemäßen Strukturen finden Verwendung als Leiterplatten, Folienverbinder und für das sogenannte "Tape-bonding".

### Beispiele

### Beispiel 1

A) Mittels einer katalytisch wirksamen Siebdruckpaste, bestehend aus
   650 Gew.-Teilen einer 30 %igen Lösung eines Polyurethanelastomers aus Butandioladipat (MG 2000), Neopentylglykol und 4,4'-Diphenylmethandiisocyanat in Propylenglykolmethyletheracetat
   330 Gew.-Teilen Glykolmethyletheracetat,
   55 Gew.-Teilen Kieselsäure Aerosil® (380 m² /g nach BET),
   52 Gew.-Teilen Pigment Blue 15 (c.I. 74 160)
   13 Gew.-Teilen Butadienpalladiumchlorid
   wird eine Folienverbinderstruktur ohne Ansatzbereiche ("pins") auf eine 125 µm PET-Folie gedruckt und der Druck 10 Minuten bei 150°C getrocknet.
B) Anschließend werden die Ansatzbereiche mit einer Paste, bestehend aus
   100 Gew.-Teilen einer 30 %igen Lösung des obigen Polyurethanelastomers, 20 Gew.-Teilen eines Farbrußes (Printex®V),
   2 Gew.-Teilen 3-Hepten-2-on-palladiumchlorid und
   2 Gew.-Teilen Diethylenglykol
   bündig angedruckt und die gedruckte Struktur 1 Stunde bei 150°C getrocknet.
   Die Drucke werden 1 Stunde in einem formalinhaltigen Kupferbad stromlos verkupfert und anschließend galvanisch auf 20 µm verstärkt.
   Man erhält einen Folienverbinder, von dem sich die Anschlußbereiche leicht mechanisch von der Trägerfolie abtrennen lassen.

### Beispiel 2:

A) Mittels einer katalytisch wirksamen Siebdruckpaste, bestehend aus
   260 Gew.-Teilen einer 20 %igen Lösung eines Polymers aus Trimellitsäureanhydrid, 4,4'-Diphenylmethandiisocyanat und ε-Caprolactam in N-Methylcaprolactam,
   130 Gew.-Teilen Methoxypropylacetat,
   2,2 Gew.-Teilen Butadienpalladiumdichlorid und
   20 Gew.-Teilen Aerosil® (380 m² /g nach BET)
   wird auf eine 75 µm Polyimid-Folie (Kapton®) eine Folienverbinderstruktur ohne Ansatzbereiche gedruckt und der Druck 10 Minuten bei 160°C getrocknet.
B) Anschließend werden Anschlußbereiche mit einer Paste, bestehend aus
   66 Gew.-Teilen einer 60 %igen Lösung einer Polymers aus 50 Gew.-Teilen Methylmethacrylat, 20 Gew.-Teilen n-Butylacrylat und 30 Gew.-Teilen Acrylnitril in Methoxypropylacetat,
   50 Gew.-Teilen Glykolmethyletheracetat,
   4 Gew.-Teilen Aerosil® (200 m²/g nach BET),
   1 Gew.-Teilen 3-Hepten-2-on-palladiumchlorid,
   bündig angedruckt und die gedruckte Struktur 1 Stunde bei 200°C getrocknet.
   Anschließend wird die bedruckte Folie 5 Stunden in einem formalinhaltigen Kupferbad stromlos verkupfert. Man erhält einen Folienverbinder, von dem sich bei schnellem Erhitzen auf 130°C die Ansatzbereiche von der Folie ablösen.

### Beispiel 3

Auf einer Polyethylenterephthalat-Folie werden die späteren Anschlußbereiche eines Folienverbinders mittels einer Schablone mit einer 0,1 %igen Lösung eines Methylpolysiloxanes in Testbenzin besprüht und getrocknet.

Anschließend wird mittels einer Siebdruckpaste gemäß Beispiel 1 A die gesamte Folienverbinderstruktur gedruckt, 1 Stunde bei 150°C getrocknet und 1 Stunde stromlos verkupfert. Danach wird die verkupferte Struktur galvanisch auf 35 µm verstärkt. Man erhält einen Folienverbinder, bei dem sich die Anschlußbereiche leicht mechanisch von der Trägerfolie ablösen läßt.

### Beispiel 4

Eine 50 µm Polyimid-Folie wird mit einer Formulierung gemäß Beispiel 2 A einseitig ganzflächig beschichtet. Die beschichtete Folie wird 45 Minuten bei 250°C getrocknet und 1 Stunde in einem formalinhaltigen Kupferbad stromlos verkupfert. Auf die Kupferfläche wird mittels eines Galvanoresists das Negativbild eines Chip-Carriers mit 84 Anschlüssen aufgebracht und galvanisch in den freistehenden Bereichen 10 µm Kupfer, ca. 2 µm Nickel und ca. 3 µm Gold aufgebaut. Nach dem Strippen des Resists werden die Kupferflächen zwischen den Leiterbahnen weggeätzt. Beidseitig wird ein alkalibeständiger Ätzresist so aufgedruckt, daß die späteren Anschluß- und Steckerbereiche frei bleiben. In diesen Bereichen wird mittels einer heißen Kalilauge das Trägermaterial weggeätzt. Nach Entfernen des Ätzresists erhält man einen Chip-Carrier mit freistehenden Anschluß- und Steckerbereichen.

### Beispiel 5

Mittels einer katalytisch wirksamen Siebdruckpaste, bestehend aus
200 Gew.-Teilen einer 20 %igen Lösung eines Polyurethanelastomers aus Butandiolpolyadipat (MG 1.500) und Toluylendiisocyanat in Propylenglykolmethyletheracetat
54 g Titandioxid
60 g Glykolsäurebutylester und
1,4 g Bis-acetonitrilpalladiumdichlorid
wird auf eine 75 µm-Folie eine Fläche aufgedruckt, bei der die späteren Anschlußbereiche ausgelassen werden. Diese Bereiche werden anschließend mit einer Paste gemäß Beispiel 2 B bedruckt.

Die bedruckten Flächen werden 1 Stunde bei 150°C getrocknet, in einem formalinhaltigen Kupferbad stromlos verkupfert und anschließend galvanisch auf 20 µm verstärkt. Mittels Ätzen nach Aufbringen eines Resists wird eine Folienverbinderstruktur erzeugt, von der sich die Steckerbereiche leicht mechanisch entfernen lassen.

## Patentansprüche

1. Verfahren zur Herstellung von ein- oder mehrlagigen elektrisch leitenden Strukturen mit Anschluß- und Steckerbereichen, die in der Ebene des Trägers über diesen hinausgehen, nachdem der ursprünglich auch unter diesen Anschlüssen und Steckern vorhandene Träger ohne deren Beschädigung abgelöst worden ist, durch Aufbringen einer organometallische Aktivatoren enthaltenden Formulierung auf die Trägeroberfläche und anschließende naßchemisch-stromlose Metallisierung, wobei sowohl die Leiterbahnen als auch die Anschluß- und Steckerbereiche in einem Arbeitsgang metallisiert werden und dabei die Metallschicht in den Anschluß- und Steckerbereichen mit einer so geringen Haftfestigkeit abgeschieden wird, daß sie leicht von der Substratoberfläche ohne deren Beschädigung abgelöst werden kann.

2. Verfahren nach Anspruch 1, dadurch gekennzeichnet, daß die Haftfestigkeit in den Anschluß- und Steckerbereichen weniger als 15 N / 25 mm (N/inch) beträgt.

3. Verfahren nach Anspruch 1, dadurch gekennzeichnet, daß für die Erzeugung von Leiterbild und Anschluß- bzw. Steckerbereich verschiedene Aktivatorformulierungen verwendet werden, die Metallschichten unterschiedlicher Haftfestigkeit ergeben.

4. Verfahren nach Anspruch 1, dadurch gekennzeichnet, daß in den Anschluß- und Steckerbereichen die Haftfestigkeit durch physikalische oder chemische Vorbehandlungen herabgesetzt wird.

5. Verfahren nach Anspruch 1, dadurch gekennzeichnet, daß für die Anschluß- und Steckerbereiche ein von dem das Leiterbild tragenden Substrat verschiedenes Substrat verwendet wird, das eine geringere Haftfestigkeit gegenüber Metallschichten aufweist.

6. Verfahren zur Herstellung von ein- oder mehrlagigen elektrisch leitenden Strukturen mit Anschluß- und Steckerbereichen, die in der Ebend des Trägers über diesen hinausgehen, nachdem der ursprünglich auch unter diesen Anschlüssen und Steckern vorhandene Träger ohne deren Beschädigung abgelöst worden ist, durch Aufbringen einer organometallische Aktivatoren enthaltenden Formulierung auf die Trägeroberfläche und anschließende naßchemisch-stromlose Metallisierung, wobei für die Anschluß- und Steckerbereiche eine thermoplastische Bindemittel enthaltende Aktivatorformulierung verwendet wird, die eine Ablösung der Metallschicht durch Erwärmen auf 60 - 300°C, vorzugsweise 100 - 250°C ermöglicht, während das Leiterbild unter diesen Bedingungen festhaftend bleibt.

7. Verfahren nach Anspruch 1 oder 6, dadurch gekennzeichnet, daß als Bindemittel Polyurethane und als Füllstoffe disperse Kieselsäuren verwendet werden.

## Claims

1. Process for fabricating mono- or multilayered electrically conductive patterns having terminal and plug connector zones which extend beyond the carrier in the plane thereof, after the carrier which had originally also been present underneath said terminals and plug connectors has been peeled off without damaging them, by applying a formulation, which contains organometallic activators, onto the carrier surface, followed by wet-chemical electroless metallization, wherein both the conductor tracks and the terminal and plug connector zones are metallized in one operation, the metal layer being deposited in the terminal and plug connector zones with such a low adhesive strength that it can easily be peeled off from the substrate surface without damaging the latter.

2. Process according to Claim 1, characterized in that the adhesive strength in the terminal and plug connector zones is less than 15 N/25 mm (N/inch).

3. Process according to Claim 1, characterized in that the conductor pattern on the one hand and the terminal and plug connector zone on the other hand are generated by different activator formulations being employed, which result in metal layers having different adhesive strength.

4. Process according to Claim 1, characterized in that the adhesive strength in the terminal and plug connector zones is reduced by physical or chemical pretreatments.

5. Process according to Claim 1, characterized in that the substrate used for the terminal and plug connector zones is different from the substrate carrying the conductor pattern and has a lower adhesive strength with respect to metal layers.

6. Process for fabricating mono- or multilayered electrically conductive patterns having terminal and plug connector zones which extend beyond the carrier in the plane thereof, after the carrier which had originally also been present underneath said terminals and plug connectors has been peeled off without damaging them, by applying a formulation, which contains organometallic activators, onto the carrier surface, followed by wet-chemical electroless metallization, which method employs, for the terminal and plug connector zones, an activator formulation which contains thermoplastic binders and which makes it possible to peel off the metal layer by heating to 60-300°C, preferably 100-250°C, while the conductor pattern continues to adhere firmly under these conditions.

7. Process according to Claim 1 or 6, characterized in that the binders used are polyurethanes and the fillers used are disperse silicic acids.

## Revendications

1. Procédé pour fabriquer des structures conductrices d'électricité à une ou plusieurs couches avec des zones de raccordement et d'enfichage en saillie par rapport à ces structures dans le plan du support, dans lequel le support se trouvant originellement également sous ces raccordements et fiches est enlevé sans endommager ceux-ci en appliquant une formulation contenant des activateurs organométalliques sur la surface du support puis une métallisation chimique par voie humide sans courant, et dans lequel tant les pistes conductrices que les zones de raccordement et d'enfichage sont métallisées en une seule phase de travail et la couche métallique dans les zones de raccordement et d'enfichage est appliquée avec une adhérence si faible qu'elle peut être détachée facilement de la surface du substrat sans l'endommager.

2. Procédé selon la revendication 1, caractérisé en ce que l'adhérence dans les zones de raccordement et d'enfichage est inférieure à 15 N / 25 mm (N/pouce).

3. Procédé selon la revendication 1, caractérisé en ce que l'on utilise pour réaliser le circuit conducteur et les zones de raccordement ou d'enfichage différentes formulations d'activateur produisant des couches métalliques de différentes adhérences.

4. Procédé selon la revendication 1, caractérisé en ce que l'adhérence dans les zones de raccordement et d'enfichage est diminuée par des traitements préalables physiques ou chimiques.

5. Procédé selon la revendication 1, caractérisé en ce que l'on utilise pour les zones de raccordement et d'enfichage un substrat différent du substrat qui porte le circuit conducteur et présente une adhérence plus faible vis-à-vis des couches métalliques.

6. Procédé pour fabriquer des structures conductrices d'électricité à une ou plusieurs couches avec des zones de raccordement et d'enfichage se trouvant en saillie dans le plan du support par rapport à celui-ci, dans lequel le support se trouvant sous ces raccordements et fiches a été détaché sans les endommager, en appliquant une formulation contenant des activateurs organométalliques sur la surface du support, suivie d'une métallisation chimique par voie humide sans courant, dans lequel on utilise pour les zones de raccordement et d'enfichage une formulation d'activateur contenant un liant thermoplastique, qui permet un détachement de la couche métallique en chauffant à une température de 60 à 300°C, de préférence de 100 à 250°C, le circuit conducteur restant adhérent dans ces conditions.

7. Procédé selon la revendication 1 ou 6, caractérisé en ce que l'on emploie comme liants des polyuréthannes et comme charges des acides siliciques dispersés.
